# EUROPEAN PATENT APPLICATION

(11) **EP 4 432 690 A1**
(43) Date of publication of application: **18.09.2024**
(21) Application number: 22913841.7
(22) Date of filing: 11.11.2022
(51) Int. Cl.: H04Q 1/00, H04Q 1/02

(54) **OPTICAL CROSS-CONNECT ARCHITECTURE AND COMMUNICATION DEVICE**

(30) Priority: 27.12.2021 CN 202111611086
(71) Applicant: Huawei Technologies Co., Ltd., Shenzhen, Guangdong 518129 (CN)
(72) Inventor: TENG, Shuangye, Shenzhen, Guangdong 518129 (CN); KONG, Fanhua, Shenzhen, Guangdong 518129 (CN); FAN, Huizhong, Shenzhen, Guangdong 518129 (CN); YAN, Bo, Shenzhen, Guangdong 518129 (CN)
(74) Representative: Thun, Clemens
(86) International application number: PCT/CN2022/131439
(87) International publication number: WO 2023/124580

(57) **Abstract**

This application provides an optical cross-connect architecture and a communication device. The optical cross-connect architecture may include: at least one front inserting board and at least one rear inserting board, where each front inserting board is orthogonal to any rear inserting board, one side of each front inserting board is disposed opposite to one side of any rear inserting board, all rear inserting boards are located on a same side of any front inserting board, and each front inserting board is pluggably connected to any rear inserting board. An optical signal distribution module is disposed in the at least one front inserting board; and/or, an optical signal distribution module is disposed in the at least one rear inserting board. In the optical cross-connect architecture in embodiments of this application, an optical backboard in a conventional technology is omitted, and interconnection space between the front inserting board and the rear inserting board is reduced, thereby helping implement a design of minimizing an interconnection depth, and increasing available space between the front inserting board and the rear inserting board.

## Description

### CROSS-REFERENCE TO RELATED APPLICATIONS

This application claims priority to Chinese Patent Application No. 202111611086.8, filed with the Chinese Patent Office on December 27, 2021 and entitled "OPTICAL CROSS-CONNECT ARCHITECTURE AND COMMUNICATION DEVICE", which is incorporated herein by reference in its entirety.

### TECHNICAL FIELD

This application relates to the field of information communication technologies, and in particular, to an optical cross-connect architecture and a communication device.

### BACKGROUND

With the continuous development of communication technologies, a cross-connect apparatus with a subrack having a depth of 600 mm to 1,200 mm has been widely used in a data center. However, most cross-connect apparatuses are all-electric devices. With the widespread application of optical devices, an optical cross-connect architecture with a subrack having a depth of 600 mm to 1,200 mm gradually emerges.

In an optical cross-connect architecture, an optical backboard is generally fastened to a subrack, and a front inserting board and a rear inserting board each are inserted into the subrack, and cross-connection is implemented between the front inserting board and the rear inserting board by using the optical backboard. The optical backboard usually includes components such as an optical fiber board (or an optical waveguide board), an optical connector, and a mechanical part, and may provide a wavelength-level connection path and a physical support function for the front inserting board and the rear inserting board. However, because space in the subrack is limited, the front inserting board and the rear inserting board are connected by using the optical backboard, and interconnection space between the front inserting board and the rear inserting board is approximately a sum of depths of connector components between the optical backboard and the front inserting board, a depth of the optical backboard, and depths of connector components between the optical backboard and the rear inserting board. In this way, the interconnection space between the front inserting board and the rear inserting board is relatively large, and available space between the front inserting board and the rear inserting board is relatively small.

### SUMMARY

Embodiments of this application provide an optical cross-connect architecture and a communication device, to resolve a problem that available space between a front inserting board and a rear inserting board is relatively small in a conventional technology.

According to a first aspect, an embodiment of this application provides an optical cross-connect architecture. The optical cross-connect architecture may include at least one front inserting board and at least one rear inserting board. In actual application, quantities of the front inserting boards and the rear inserting boards may be set based on an actual requirement, which is not limited herein. Each front inserting board is orthogonal to any rear inserting board, one side face of each front inserting board is disposed opposite to one side face of any rear inserting board, and each rear inserting board is located on a same side of any front inserting board. Each front inserting board is pluggably connected to any rear inserting board. An optical signal distribution module is disposed in the at least one front inserting board; and/or, an optical signal distribution module is disposed in the at least one rear inserting board. In other words, the optical signal distribution module may be disposed in the at least one front inserting board. Alternatively, the optical signal distribution module may be disposed in the at least one rear inserting board. Alternatively, the optical signal distribution module may be disposed in both the at least one front inserting board and the at least one rear inserting board.

In the optical cross-connect architecture provided in this embodiment of this application, the optical signal distribution module is disposed in the front inserting board and/or the rear inserting board, and each front inserting board is connected to any rear inserting board, so that optical signal transmission between the front inserting board and the rear inserting board can be implemented. In this way, an optical signal transmission function of an optical backboard in a conventional technology can be replaced. In addition, each front inserting board is orthogonal to any rear inserting board, one side face of each front inserting board is disposed opposite to one side face of any rear inserting board, each rear inserting board is located on a same side of the front inserting board, and each front inserting board is pluggably connected to any rear inserting board. In this way, physical support can be implemented between the front inserting board and the rear inserting board, and a physical support function of the optical backboard in the conventional technology can be replaced. Therefore, in the optical cross-connect architecture in this embodiment of this application, the optical backboard in the conventional technology can be omitted, and interconnection space between the front inserting board and the rear inserting board is reduced. In this way, space in a subrack is fully utilized, a design of a minimum interconnection depth is implemented, available space between the front inserting board and the rear inserting board is increased, and more functions can be integrated into the front inserting board and the rear inserting board. In addition, because insertion loss of the optical cross-connect architecture is related to a quantity of nodes, the optical backboard is omitted in the optical cross-connect architecture in this embodiment of this application, and the front inserting board and the rear inserting board may be directly docked. In this way, the quantity of nodes and the insertion loss of the optical cross-connect architecture in this embodiment of this application are reduced. For example, the insertion loss may be reduced to less than 1 dB.

The front inserting board in this embodiment of this application may implement functions such as service access, service processing, and service switching. The front inserting board may be any board that can transmit an optical signal, such as a line card (Line Card, LC) or a switch card (Fabric Card, FC). Similarly, the rear inserting board in this embodiment of this application may also implement functions such as the service access, the service processing, and the service switching. The rear inserting board may be any board that can transmit an optical signal, such as the line card (Line Card, LC) or the switch card (Fabric Card, FC).

In a possible implementation, the optical signal distribution module may include at least one optical signal receiving end, at least one optical signal output end, and an optical signal distribution component. The optical signal distribution component is configured to distribute an optical signal of each optical signal receiving end to each optical signal output end.

In specific implementation, if the optical signal distribution module is disposed in the front inserting board, each optical signal output end may be respectively connected to each rear inserting board in a form of an optical signal, and the optical signal distribution component may distribute the optical signal of each optical signal receiving end to each optical signal output end. Therefore, the optical signal of each optical signal receiving end is transmitted to each rear inserting board. Similarly, if the optical signal distribution module is disposed in the rear inserting board, each optical signal output end may be respectively connected to each front inserting board in a form of an optical signal, and the optical signal distribution component may distribute the optical signal of each optical signal receiving end to each optical signal output end. Therefore, the optical signal of each optical signal receiving end is transmitted to each front inserting board.

In specific implementation, the optical signal distribution component may include an optical component such as an optical fiber or an optical waveguide. Alternatively, the optical signal distribution component may also include another optical component, provided that a function of the optical signal distribution component can be implemented.

In a possible implementation, a first optical connector is disposed on at least one side of the front inserting board, and a second optical connector is disposed on at least one side of the rear inserting board. The front inserting board is pluggably connected to the rear inserting board by using the first optical connector and the second optical connector. In this embodiment of this application, the front inserting board and the rear inserting board implement optical channel interconnection by using an optical connector. The optical connector occupies relatively small space, so that the interconnection space between the front inserting board and the rear inserting board may be relatively small. In this embodiment of this application, the first optical connector may be disposed on a surface of the front inserting board. In specific implementation, the first optical connector may also be disposed on a side face of the front inserting board facing the rear inserting board. A position of the first optical connector may be determined based on an actual situation. This is not limited herein. Similarly, the second optical connector may be disposed on a surface of the rear inserting board, or the second optical connector may be disposed on a side face of the rear inserting board facing the front inserting board. A position of the second optical connector may be determined based on an actual situation. This is not limited herein. In specific implementation, each front inserting board and any rear inserting board may implement an optical signal connection by using one pair, two pairs, or more pairs of optical connectors. Each pair of optical connectors includes one first optical connector and one second optical connector. A quantity of first optical connectors and a quantity of second optical connectors may be set based on an actual requirement. This is not limited herein.

In a possible implementation, the at least one front inserting board may be pluggably connected to the at least one rear inserting board by using at least two first optical connectors and at least two second optical connectors. That is, the at least one front inserting board and the at least one rear inserting board may implement the optical signal connection by using at least two pairs of optical connectors. The at least two first optical connectors may be disposed on one side of the front inserting board in a stacked manner, and the at least two second optical connectors may be disposed on one side of the rear inserting board in a stacked manner. Alternatively, the at least two first optical connectors may be distributed on two sides of the front inserting board, and the at least two second optical connectors may be distributed on two sides of the rear inserting board. In this way, a plurality of optical signal connection paths may exist between the front inserting board and the rear inserting board. In specific implementation, positions and a quantity of optical connectors may be determined based on actual space between the front inserting board and the rear inserting board. This is not limited herein.

In specific implementation, if the optical signal distribution module is disposed in the front inserting board, the first optical connector may be set to be connected to the optical signal output end in a form of an optical signal, so that the optical signal of the front inserting board may be transmitted to the rear inserting board. If the optical signal distribution module is disposed in the rear inserting board, the second optical connector may be set to be connected to the optical signal output end in a form of an optical signal, so that the optical signal of the rear inserting board may be transmitted to the front inserting board.

Optionally, the first optical connector (or the second optical connector) may be various types of optical connectors such as an MT optical fiber connector, a multi-core multi-channel pluggable (MPO) optical fiber connector, or an LC-type optical fiber connector. In actual application, the first optical connector (or the second optical connector) may be fastened to a printed circuit board (Printed Circuit Board, PCB) or an optical component of the front inserting board (or the rear inserting board) by using a screw. Alternatively, the first optical connector or the second optical connector may be fastened in another manner, which is not limited herein.

In actual application, a first optical component may be disposed on the surface of the front inserting board, and the first optical connector is connected to the front inserting board in a form of an optical signal by using the first optical component. An optical signal connection between the front inserting board and the first optical connector may be implemented by using a transfer function of the first optical component. A second optical component is disposed on the surface of the rear inserting board, and the second optical connector is connected to the rear inserting board in a form of an optical signal by using the second optical component. An optical signal connection between the rear inserting board and the second optical connector may be implemented by using a transfer function of the second optical component.

In some embodiments of this application, when the front inserting board and the rear inserting board implement the optical signal connection by using the at least two pairs of optical connectors, the first optical component is disposed, so that the at least two first optical connectors may be disposed in a stacked manner, or the at least two first optical connectors may be distributed on two sides of the front inserting board. Similarly, the second optical component is disposed so that the at least two second optical connectors may be disposed in a stacked manner, or the at least two second optical connectors may be distributed on two sides of the rear inserting board.

Optionally, the first optical component may include any component having an optical signal transmission function, such as an optical mechanical part or an optical module. The second optical component may include any component having an optical signal transmission function, such as an optical mechanical part or an optical module.

In a possible implementation, the optical cross-connect architecture may include one front inserting board and a plurality of rear inserting boards, and the optical signal distribution module may be disposed in the front inserting board. Each rear inserting board may be respectively connected to each optical signal output end of the optical signal distribution module in a form of an optical signal, and the optical signal of the front inserting board is respectively transmitted to each rear inserting board by using a distribution and transmission function of the optical signal distribution module. In this way, optical signal transmission between the front inserting board and the rear inserting board is implemented. Certainly, the optical signal distribution module may also be disposed in the rear inserting board, which is not limited herein.

In another possible implementation, the optical cross-connect architecture may include one rear inserting board and a plurality of front inserting boards, and the optical signal distribution module may be disposed in the rear inserting board. Each front inserting board may be respectively connected to each optical signal output end of the optical signal distribution module in a form of an optical signal, and the optical signal of the rear inserting board is respectively transmitted to each front inserting board by using the distribution and transmission function of the optical signal distribution module. Certainly, the optical signal distribution module may also be disposed in the front inserting board, which is not limited herein.

In another possible implementation, the optical cross-connect architecture may include a plurality of front inserting boards and a plurality of rear inserting boards, and the optical signal distribution module may be disposed in the at least one front inserting board. Each rear inserting board may be respectively connected to each optical signal output end of the optical signal distribution module in a form of an optical signal, and the optical signal of the front inserting board is respectively transmitted to each rear inserting board by using the distribution and transmission function of the optical signal distribution module. Alternatively, the optical signal distribution module may be disposed in the at least one rear inserting board. Each front inserting board may be respectively connected to each optical signal output end of the optical signal distribution module in a form of an optical signal, and the optical signal of the rear inserting board is respectively transmitted to each front inserting board by using the distribution and transmission function of the optical signal distribution module. Optionally, the optical signal distribution module may be disposed in each front inserting board and each rear inserting board, so that optical signal transmission between the plurality of front inserting boards and the plurality of rear inserting boards can be implemented.

In some other embodiments of this application, an electrical signal transmission module is disposed in the at least one front inserting board; and/or an electrical signal transmission module is disposed in the at least one rear inserting board. In other words, the electrical signal transmission module may be disposed in the at least one front inserting board. Alternatively, the electrical signal transmission module may be disposed in the at least one rear inserting board. Alternatively, the electrical signal transmission module may be disposed in both the at least one front inserting board and the at least one rear inserting board. In this embodiment of this application, the electrical signal transmission module may be a component having an electrical signal transmission function, such as a chip. Optionally, the electrical signal transmission module may include a conductive component such as a metal wire or a cable.

In this embodiment of this application, the electrical signal transmission module is disposed in the front inserting board and/or the rear inserting board, so that an electrical signal connection between the front inserting board and the rear inserting board can be implemented, and electrical signal transmission between the front inserting board and the rear inserting board can be implemented. In this way, the optical cross-connect architecture in this embodiment of this application also has a function of processing an electrical-layer service, and an optical-electrical hybrid backboard-free orthogonal architecture is implemented.

In this embodiment of this application, the electrical signal transmission module has at least one electrical signal receiving end and at least one electrical signal output end. The electrical signal transmission module is configured to transmit an electrical signal of each electrical signal receiving end to each electrical signal output end.

In specific implementation, if the electrical signal transmission module is disposed in the front inserting board, each electrical signal output end of the electrical signal transmission module may be respectively connected to each rear inserting board in a form of an electrical signal. The electrical signal transmission module may transmit an electrical signal of each electrical signal receiving end to each electrical signal output end. Therefore, the electrical signal of each electrical signal receiving end is respectively transmitted to each rear inserting board. Similarly, if the electrical signal transmission module is disposed in the rear inserting board, each electrical signal output end of the electrical signal transmission module may be respectively connected to each front inserting board in a form of an electrical signal. The electrical signal transmission module may transmit the electrical signal of each electrical signal receiving end to each electrical signal output end. Therefore, the electrical signal of each electrical signal receiving end is respectively transmitted to each front inserting board.

In a possible implementation, a first electrical connector is disposed on at least one side of the front inserting board, and a second electrical connector is disposed on at least one side of the rear inserting board. The front inserting board is pluggably connected to the rear inserting board by using the first electrical connector and the second electrical connector. In this embodiment of this application, the front inserting board and the rear inserting board implement the electrical signal connection by using an electrical connector, and the electrical connector occupies relatively small space, so that the interconnection space between the front inserting board and the rear inserting board may be relatively small. In specific implementation, the first electrical connector may be disposed on the surface of the front inserting board. Alternatively, the first electrical connector may be disposed on a side of the front inserting board facing the rear inserting board, and a position of the first electrical connector may be determined based on an actual situation, which is not limited herein. Similarly, the second electrical connector may be disposed on the surface of the rear inserting board. Alternatively, the second electrical connector may be disposed on a side of the rear inserting board facing the front inserting board, and a position of the second electrical connector may be determined based on an actual situation, which is not limited herein. In specific implementation, each front inserting board and any rear inserting board may implement the electrical signal connection by using one pair, two pairs, or more pairs of electrical connectors. Each pair of electrical connectors includes one first electrical connector and one second electrical connector. A quantity of first electrical connectors and a quantity of second electrical connectors may be set based on an actual requirement. This is not limited herein.

For example, the first electrical connector and the second electrical connector may be an elbow male connector and an elbow female connector respectively. Alternatively, the first electrical connector and the second electrical connector may be a spring plate and a contact respectively. Alternatively, the first electrical connector and the second electrical connector may be other structures that can implement the electrical signal connection. This is not limited herein.

In actual application, the first electrical connector may be electrically connected to the front inserting board by crimping, welding, or the like, and the second electrical connector may be electrically connected to the rear inserting board by crimping, welding, or the like. Therefore, usually, the first electrical connector is disposed on the surface of the front inserting board, and the second electrical connector is disposed on the surface of the rear inserting board.

In a possible implementation, the at least one front inserting board may be pluggably connected to the at least one rear inserting board by using at least two first electrical connectors and at least two second electrical connectors. In other words, the at least one front inserting board and the at least one rear inserting board may implement the electrical signal connection by using at least two pairs of electrical connectors. In specific implementation, the at least two first electrical connectors may be disposed on two sides of the front inserting board, and the at least two second electrical connectors may be disposed on two sides of the rear inserting board. In specific implementation, positions and a quantity of electrical connectors may be determined based on space between the front inserting board and the rear inserting board. This is not limited herein.

In some embodiments of this application, the optical connector and the electrical connector are required to connect the front inserting board and the rear inserting board. Because the electrical connector is usually electrically connected to the front inserting board or the rear inserting board by crimping, welding, or the like, the electrical connector is usually disposed on the surface of the front inserting board or the rear inserting board. Therefore, the first electrical connector needs to be disposed on the surface of the front inserting board, and the second electrical connector needs to be disposed on the surface of the rear inserting board. To properly use the interconnection space between the front inserting board and the rear inserting board, the first optical connector and the first electrical connector may be disposed in a stacked manner. To implement the optical signal connection between the first optical connector and the front inserting board, the first optical component may be further disposed on the surface of the front inserting board, and the first optical connector is connected to the surface of the front inserting board by using the first optical component. In this way, optical signal transmission between the first optical connector and the front inserting board may be implemented by using the transfer function of the first optical component. In addition, the interconnection space between the front inserting board and the rear inserting board may be properly used, so that the positions of each optical connector and each electrical connector are relatively compact, and the interconnection space between the front inserting board and the rear inserting board is relatively small.

In addition, in some other embodiments of this application, the second optical connector and the second electrical connector may also be disposed in a stacked manner in a direction perpendicular to the surface of the rear inserting board. In this way, the second optical component may be disposed on the surface of the rear inserting board, so that the second optical connector is connected to the surface of the rear inserting board by using the second optical component.

In specific implementation, devices such as a pluggable optical module and an optical signal processing chip may be disposed on the surface of the front inserting board and/or the rear inserting board. The optical signal processing chip may be a service processing chip, a cross processing chip, a wavelength processing chip, or the like. The pluggable optical module and the optical signal processing chip each are connected to the optical connector by using the optical signal distribution module. A medium of the optical signal distribution module may be an optical fiber, a ribbon fiber, or a waveguide medium. In addition, an electrical signal processing chip may be further disposed on the surface of the front inserting board and/or the rear inserting board, and the electrical signal processing chip may be an electrical-layer service processing chip, a cross-connect chip, or the like. The electrical signal processing chip may be connected to the electrical connector by using the electrical signal transmission module, and a medium of the electrical signal transmission module may be a copper wire, a cable, or the like.

In a possible implementation, the optical cross-connect architecture may include one front inserting board and a plurality of rear inserting boards, and the electrical signal transmission module may be disposed in the front inserting board. Each rear inserting board may be respectively connected to each electrical signal output end of the electrical signal transmission module in a form of an electrical signal, and an electrical signal of the front inserting board is transmitted to each rear inserting board by using a transmission function of the electrical signal transmission module. In this way, electrical signal transmission between the front inserting board and the rear inserting board is implemented. Certainly, the electrical signal transmission module may also be disposed in the rear inserting board, which is not limited herein.

In another possible implementation, the optical cross-connect architecture may include one rear inserting board and a plurality of front inserting boards, and the electrical signal transmission module may be disposed in the rear inserting board. Each front inserting board may be respectively connected to each electrical signal output end of the electrical signal transmission module in a form of an electrical signal, and the electrical signal of the rear inserting board is transmitted to each front inserting board by using the transmission function of the electrical signal transmission module. In this way, the electrical signal transmission between the front inserting board and the rear inserting board is implemented. Certainly, the electrical signal transmission module may also be disposed in the front inserting board, which is not limited herein.

In another possible implementation, the optical cross-connect architecture may include a plurality of front inserting boards and a plurality of rear inserting boards, and the electrical signal transmission module may be disposed in the at least one front inserting board. Each rear inserting board may be respectively connected to each electrical signal output end of the electrical signal transmission module in a form of an electrical signal, and the electrical signal of the front inserting board is transmitted to each rear inserting board by using the transmission function of the electrical signal transmission module. In this way, the electrical signal transmission between the front inserting board and the rear inserting board is implemented. Alternatively, the electrical signal transmission module may be disposed in the at least one rear inserting board. Each front inserting board may be respectively connected to each electrical signal output end of the electrical signal transmission module in a form of an electrical signal, and the electrical signal of the rear inserting board is transmitted to each front inserting board by using the transmission function of the electrical signal transmission module. In this way, the electrical signal transmission between the front inserting board and the rear inserting board is implemented. Optionally, the electrical signal transmission module may be disposed in each front inserting board and each rear inserting board, so that the electrical signal connection between the plurality of front inserting boards and the plurality of rear inserting boards can be implemented.

Based on a same technical concept, an embodiment of this application further provides a communication device. The communication device may include any one of the foregoing optical cross-connect architectures and a housing. The housing covers the optical cross-connect architecture. The communication device may be an optical communication device, a router, a switch, a server, or the like. Because an optical backboard in a conventional technology is omitted in the foregoing optical cross-connect architecture, the interconnection space between the front inserting board and the rear inserting board in the optical cross-connect architecture is relatively small, and available space between the front inserting board and the rear inserting board is relatively large. In this way, the front inserting board and the rear inserting board can integrate more functions, and functions of the communication device including the optical cross-connect architecture are enriched. In addition, a distance between the front inserting board and the rear inserting board is relatively short, and insertion loss of the optical cross-connect architecture is relatively small, so that performance of the communication device including the optical cross-connect architecture is relatively good.

### BRIEF DESCRIPTION OF DRAWINGS

FIG. 1 is a schematic diagram of a three-dimensional structure of an optical cross-connect architecture according to an embodiment of this application;
FIG. 2 is a schematic diagram of a structure of an optical signal distribution module according to an embodiment of this application;
FIG. 3 is another schematic diagram of a three-dimensional structure of an optical cross-connect architecture according to an embodiment of this application;
FIG. 4 is another schematic diagram of a three-dimensional structure of an optical cross-connect architecture according to an embodiment of this application;
FIG. 5 is another schematic diagram of a three-dimensional structure of an optical cross-connect architecture according to an embodiment of this application;
FIG. 6 is a schematic diagram of a structure of an electrical signal transmission module according to an embodiment of this application;
FIG. 7 is another schematic diagram of a three-dimensional structure of an optical cross-connect architecture according to an embodiment of this application;
FIG. 8 is another schematic diagram of a three-dimensional structure of an optical cross-connect architecture according to an embodiment of this application; and
FIG. 9 is another schematic diagram of a three-dimensional structure of an optical cross-connect architecture according to an embodiment of this application.

### Reference numerals:

11-front inserting board; 12-rear inserting board; 13-first optical connector; 14-second optical connector; 15-first electrical connector; 16-second electrical connector; 21-pluggable module; 22-optical signal processing chip; 23-electrical signal processing chip; 201-optical signal receiving end; 202-optical signal output end; 203-optical signal distribution component; 300-electrical signal transmission module; 301-electrical signal receiving end; 302-electrical signal output end.

### DESCRIPTION OF EMBODIMENTS

To make the objectives, technical solutions, and advantages of this application clearer, the following further describes this application in detail with reference to the accompanying drawings.

It should be noted that same reference numerals in the accompanying drawings of this application represent same or similar structures, and therefore repeated descriptions thereof are omitted. Expressions of positions and directions in this application are described by using the accompanying drawings as an example. However, changes may also be made as required, and all the changes fall within the protection scope of this application. The accompanying drawings in this application are merely used to illustrate relative position relationships and do not represent an actual scale.

To resolve a problem that available space between the front inserting board and the rear inserting board is relatively small in the conventional technology, embodiments of this application provide an optical cross-connect architecture and a communication device. The optical backboard interconnection apparatus may be applied to various types of communication devices. For example, the communication device may be an optical communication device, a router, a switch, a server, and the like. Certainly, the optical cross-connect architecture may also be applied to other types of communication devices, which is not limited herein.

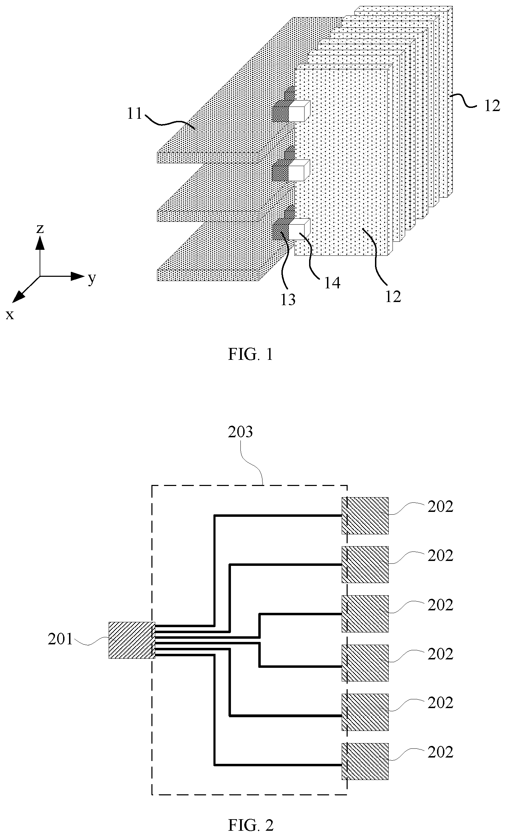

FIG. 1 is a schematic diagram of a three-dimensional structure of an optical cross-connect architecture according to an embodiment of this application. As shown in FIG. 1, the optical cross-connect architecture provided in this embodiment of this application may include at least one front inserting board 11 and at least one rear inserting board 12. Each front inserting board 11 is orthogonal to any rear inserting board 12, one side face of each front inserting board 11 is disposed opposite to one side face of any rear inserting board 12, and each rear inserting board 12 is located on a same side of any front inserting board 11. Each front inserting board 11 is pluggably connected to any rear inserting board 12. An optical signal distribution module (not shown in the figure) is disposed in the at least one front inserting board 11; and/or an optical signal distribution module (not shown in the figure) is disposed in the at least one rear inserting board 12. In other words, the optical signal distribution module may be disposed in the at least one front inserting board 11. Alternatively, the optical signal distribution module may be disposed in the at least one rear inserting board 12. Alternatively, the optical signal distribution module may be disposed in both the at least one front inserting board 11 and the at least one rear inserting board 12.

In the optical cross-connect architecture provided in this embodiment of this application, the optical signal distribution module is disposed in the front inserting board and/or the rear inserting board, and each front inserting board is connected to any rear inserting board, so that optical signal transmission between the front inserting board and the rear inserting board can be implemented. In this way, an optical signal transmission function of an optical backboard in a conventional technology can be replaced. In addition, each front inserting board is orthogonal to any rear inserting board, one side face of each front inserting board is disposed opposite to one side face of any rear inserting board, each rear inserting board is located on a same side of the front inserting board, and each front inserting board is pluggably connected to any rear inserting board. In this way, physical support can be implemented between the front inserting board and the rear inserting board, and a physical support function of the optical backboard in the conventional technology can be replaced. Therefore, in the optical cross-connect architecture in this embodiment of this application, the optical backboard in the conventional technology can be omitted, and interconnection space between the front inserting board and the rear inserting board is reduced. In this way, space in a subrack is fully utilized, a design of a minimum interconnection depth is implemented, available space between the front inserting board and the rear inserting board is increased, and more functions can be integrated into the front inserting board and the rear inserting board. In addition, because insertion loss of the optical cross-connect architecture is related to a quantity of nodes, the optical backboard is omitted in the optical cross-connect architecture in this embodiment of this application, and the front inserting board and the rear inserting board may be directly docked. In this way, the quantity of nodes and the insertion loss of the optical cross-connect architecture in this embodiment of this application are reduced. For example, the insertion loss may be reduced to about 1 dB.

To clearly show positions of components in the optical cross-connect architecture, an xyz coordinate system is identified in the accompanying drawings in this embodiment of this application. As shown in FIG. 1, when each front inserting board 11 in the optical cross-connect architecture is parallel to an xy plane, each rear inserting board 12 may be disposed to be parallel to a yz plane, so that the front inserting board 11 is orthogonal to the rear inserting board 12. In FIG. 1, an example in which the front inserting board 11 is horizontally placed and the rear inserting board 12 is vertically placed is used for illustration. In specific implementation, positions of the front inserting board 11 and the rear inserting board 12 may be determined based on an actual requirement, which is not limited herein. In FIG. 1, an example in which the optical cross-connect architecture in this embodiment of this application includes three front inserting boards 11 and six rear inserting boards 12 is used for description. In actual application, quantities of the front inserting boards 11 and the rear inserting boards 12 may be set based on an actual requirement, which is not limited herein.

The front inserting board 11 in this embodiment of this application may implement functions such as service access, service processing, and service switching. The front inserting board 11 may be any board that can transmit an optical signal, such as a line card (Line Card, LC) or a switch card (Fabric Card, FC). Similarly, the rear inserting board 12 in this embodiment of this application may also implement functions such as the service access, the service processing, and the service switching. The rear inserting board 12 may be any board that can transmit an optical signal, such as the line card (Line Card, LC) or the switch card (Fabric Card, FC).

FIG. 2 is a schematic diagram of a structure of an optical signal distribution module according to an embodiment of this application. As shown in FIG. 2, the optical signal distribution module may include at least one optical signal receiving end 201, at least one optical signal output end 202, and an optical signal distribution component 203. The optical signal distribution component 203 is configured to distribute an optical signal of each optical signal receiving end 201 to each optical signal output end 202.

In specific implementation, if the optical signal distribution module is disposed in the front inserting board, each optical signal output end 202 may be respectively connected to each rear inserting board in a form of an optical signal, and the optical signal distribution component 203 may distribute the optical signal of each optical signal receiving end 201 to each optical signal output end 202. Therefore, the optical signal of each optical signal receiving end 201 is transmitted to each rear inserting board. Similarly, if the optical signal distribution module is disposed in the rear inserting board, each optical signal output end 202 may be respectively connected to each front inserting board in a form of an optical signal, and the optical signal distribution component 203 may distribute the optical signal of each optical signal receiving end 201 to each optical signal output end 202. Therefore, the optical signal of each optical signal receiving end 201 is transmitted to each front inserting board.

In specific implementation, the optical signal distribution component 203 may include an optical component such as an optical fiber or an optical waveguide. Alternatively, the optical signal distribution component 203 may include another optical component, provided that a function of the optical signal distribution component 203 can be implemented.

In a possible implementation, still with reference to FIG. 1, a first optical connector 13 is disposed on at least one side of the front inserting board 11, a second optical connector 14 is disposed on at least one side of the rear inserting board 12, and the front inserting board 11 is pluggably connected to the rear inserting board 12 by using the first optical connector 13 and the second optical connector 14. In this embodiment of this application, the front inserting board 11 and the rear inserting board 12 implement optical channel interconnection by using an optical connector. The optical connector occupies relatively small space, so that the interconnection space between the front inserting board 11 and the rear inserting board 12 may be relatively small. In this embodiment of this application, the first optical connector 13 may be disposed on a surface of the front inserting board 11. In specific implementation, the first optical connector 13 may also be disposed on a side face of the front inserting board 11 facing the rear inserting board 12. A position of the first optical connector 13 may be determined based on an actual situation. This is not limited herein. Similarly, the second optical connector 14 may be disposed on a surface of the rear inserting board 12, or the second optical connector 14 may be disposed on a side face of the rear inserting board 12 facing the front inserting board 11. A position of the second optical connector 14 may be determined based on an actual situation. This is not limited herein. In specific implementation, each front inserting board 11 and any rear inserting board 12 may implement an optical signal connection by using one pair, two pairs, or more pairs of optical connectors. Each pair of optical connectors includes one first optical connector 13 and one second optical connector 14. A quantity of first optical connectors 13 and a quantity of second optical connectors 14 may be set based on an actual requirement. This is not limited herein.

In a possible implementation, the at least one front inserting board may be pluggably connected to the at least one rear inserting board by using at least two first optical connectors and at least two second optical connectors. That is, the at least one front inserting board and the at least one rear inserting board may implement the optical signal connection by using at least two pairs of optical connectors. The at least two first optical connectors may be disposed on one side of the front inserting board in a stacked manner, and the at least two second optical connectors may be disposed on one side of the rear inserting board in a stacked manner. Alternatively, the at least two first optical connectors may be distributed on two sides of the front inserting board, and the at least two second optical connectors may be distributed on two sides of the rear inserting board. In this way, a plurality of optical signal connection paths may exist between the front inserting board and the rear inserting board. In specific implementation, positions and a quantity of optical connectors may be determined based on actual space between the front inserting board and the rear inserting board. This is not limited herein.

In specific implementation, with reference to FIG. 1 and FIG. 2, if the optical signal distribution module is disposed in the front inserting board 11, the first optical connector 13 may be set to be connected to the optical signal output end 202 in a form of an optical signal, so that the optical signal of the front inserting board 11 may be transmitted to the rear inserting board. If the optical signal distribution module is disposed in the rear inserting board 12, the second optical connector 14 may be set to be connected to the optical signal output end 202 in a form of an optical signal, so that the optical signal of the rear inserting board 12 may be transmitted to the front inserting board.

Optionally, the first optical connector 13 (or the second optical connector 14) may be various types of optical connectors such as an MT optical fiber connector, a multi-core multi-channel pluggable (MPO) optical fiber connector, or an LC-type optical fiber connector. In actual application, the first optical connector 13 (or the second optical connector 14) may be fastened to a printed circuit board (Printed Circuit Board, PCB) or an optical component of the front inserting board 11 (or the rear inserting board 12) by using a screw. Alternatively, the first optical connector 13 or the second optical connector 14 may be fastened in another manner, which is not limited herein.

In actual application, with reference to FIG. 1, a first optical component (not shown in the figure) may be disposed on the surface of the front inserting board 11, and the first optical connector 13 is connected to the front inserting board 11 in a form of an optical signal by using the first optical component. An optical signal connection between the front inserting board 11 and the first optical connector 13 may be implemented by using a transfer function of the first optical component. A second optical component (not shown in the figure) is disposed on the surface of the rear inserting board 12, and the second optical connector 14 is connected to the rear inserting board 12 in a form of an optical signal by using the second optical component. An optical signal connection between the rear inserting board 12 and the second optical connector 14 may be implemented by using a transfer function of the second optical component.

In some embodiments of this application, when the front inserting board and the rear inserting board implement the optical signal connection by using the at least two pairs of optical connectors, the first optical component is disposed, so that the at least two first optical connectors may be disposed in a stacked manner, or the at least two first optical connectors may be distributed on two sides of the front inserting board. Similarly, the second optical component is disposed so that the at least two second optical connectors may be disposed in a stacked manner, or the at least two second optical connectors may be distributed on two sides of the rear inserting board.

Optionally, the first optical component may include any component having an optical signal transmission function, such as an optical mechanical part or an optical module. The second optical component may include any component having an optical signal transmission function, such as an optical mechanical part or an optical module.

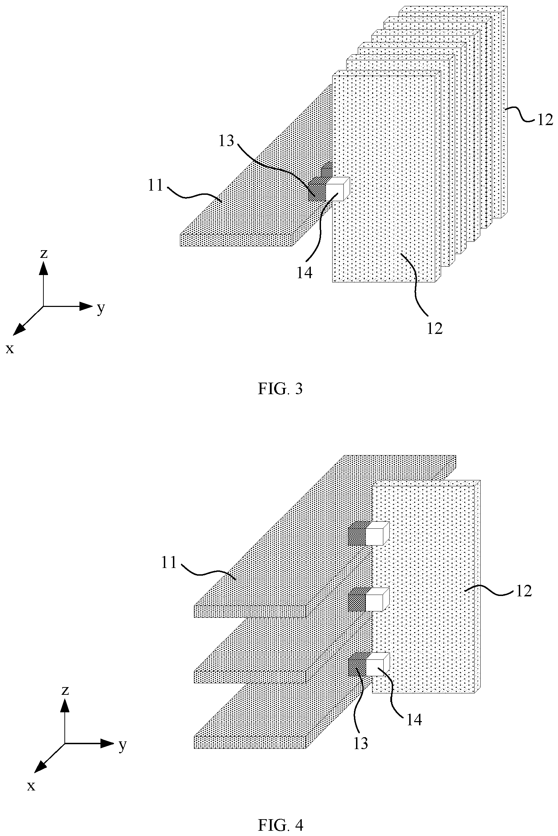

FIG. 3 is another schematic diagram of a three-dimensional structure of an optical cross-connect architecture according to an embodiment of this application. As shown in FIG. 3, the optical cross-connect architecture may include one front inserting board 11 and a plurality of rear inserting boards 12, and the optical signal distribution module may be disposed in the front inserting board 11. Each rear inserting board 12 may be respectively connected to each optical signal output end of the optical signal distribution module in a form of an optical signal, and the optical signal of the front inserting board 11 is respectively transmitted to each rear inserting board 12 by using a distribution and transmission function of the optical signal distribution module. In this way, optical signal transmission between the front inserting board 11 and the rear inserting board 12 is implemented. Certainly, the optical signal distribution module may also be disposed in the rear inserting board 12, which is not limited herein.

FIG. 4 is another schematic diagram of a three-dimensional structure of an optical cross-connect architecture according to an embodiment of this application. As shown in FIG. 4, the optical cross-connect architecture may include one rear inserting board 12 and a plurality of front inserting boards 11, and the optical signal distribution module may be disposed in the rear inserting board 12. Each front inserting board 11 may be respectively connected to each optical signal output end of the optical signal distribution module in a form of an optical signal, and the optical signal of the rear inserting board 12 is respectively transmitted to each front inserting board 11 by using the distribution and transmission function of the optical signal distribution module. Certainly, the optical signal distribution module may also be disposed in the front inserting board 11, which is not limited herein.

In some embodiments of this application, as shown in FIG. 1, the optical cross-connect architecture may include a plurality of front inserting boards 11 and a plurality of rear inserting boards 12. The optical signal distribution module may be disposed in the at least one front inserting board 11. Each rear inserting board 12 may be respectively connected to each optical signal output end of the optical signal distribution module in a form of an optical signal, and the optical signal of the front inserting board 11 is respectively transmitted to each rear inserting board 12 by using the distribution and transmission function of the optical signal distribution module. Alternatively, the optical signal distribution module may be disposed in the at least one rear inserting board 12. Each front inserting board 11 may be respectively connected to each optical signal output end of the optical signal distribution module in a form of an optical signal, and the optical signal of the rear inserting board 12 is respectively transmitted to each front inserting board 11 by using the distribution and transmission function of the optical signal distribution module. Optionally, the optical signal distribution module may be disposed in each front inserting board 11 and each rear inserting board 12, so that optical signal transmission between the plurality of front inserting boards 11 and the plurality of rear inserting boards 12 can be implemented.

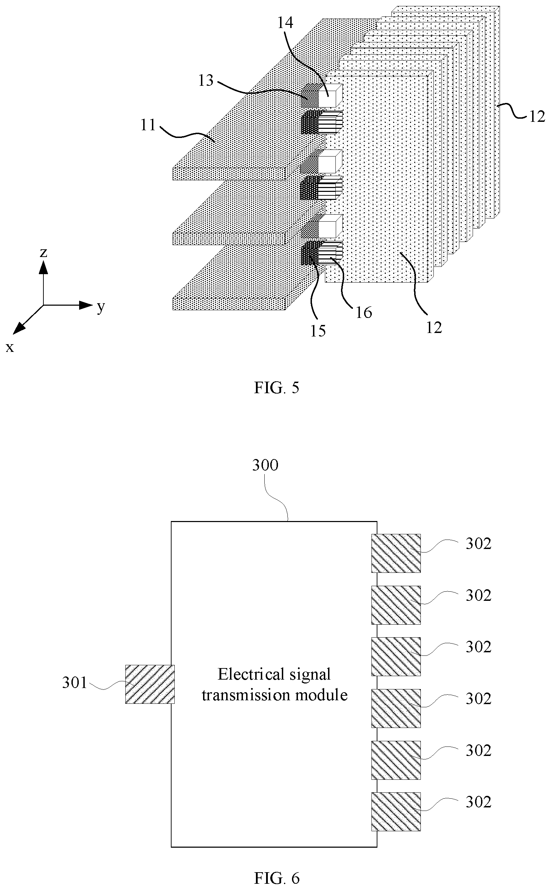

FIG. 5 is another schematic diagram of a three-dimensional structure of an optical cross-connect architecture according to an embodiment of this application. As shown in FIG. 5, an electrical signal transmission module (not shown in the figure) is disposed in the at least one front inserting board 11; and/or an electrical signal transmission module (not shown in the figure) is disposed in the at least one rear inserting board 12. In other words, the electrical signal transmission module may be disposed in the at least one front inserting board 11. Alternatively, the electrical signal transmission module may be disposed in the at least one rear inserting board 12. Alternatively, the electrical signal transmission module may be disposed in both the at least one front inserting board 11 and the at least one rear inserting board 12. In this embodiment of this application, the electrical signal transmission module may be a component having an electrical signal transmission function, such as a chip. Optionally, the electrical signal transmission module may include a conductive component such as a metal wire or a cable.

In this embodiment of this application, the electrical signal transmission module is disposed in the front inserting board 11 and/or the rear inserting board 12, so that electrical signal transmission between the front inserting board 11 and the rear inserting board 12 can be implemented. In this way, the optical cross-connect architecture in this embodiment of this application also has a function of processing an electrical-layer service, and an optical-electrical hybrid backboard-free orthogonal architecture is implemented.

FIG. 6 is a schematic diagram of a structure of an electrical signal transmission module according to an embodiment of this application. As shown in FIG. 6, the electrical signal transmission module 300 has at least one electrical signal receiving end 301 and at least one electrical signal output end 302. The electrical signal transmission module 300 is configured to transmit an electrical signal of each electrical signal receiving end 301 to each electrical signal output end 302.

In specific implementation, if the electrical signal transmission module 300 is disposed in the front inserting board, each electrical signal output end 302 of the electrical signal transmission module 300 may be respectively connected to each rear inserting board in a form of an electrical signal. The electrical signal transmission module 300 may transmit an electrical signal of each electrical signal receiving end 301 to each electrical signal output end 302. Therefore, the electrical signal of each electrical signal receiving end 301 is respectively transmitted to each rear inserting board. Similarly, if the electrical signal transmission module 300 is disposed in the rear inserting board, each electrical signal output end 302 of the electrical signal transmission module 300 may be respectively connected to each front inserting board in a form of an electrical signal. The electrical signal transmission module 300 may transmit the electrical signal of each electrical signal receiving end 301 to each electrical signal output end 302. Therefore, the electrical signal of each electrical signal receiving end 301 is respectively transmitted to each front inserting board.

In a possible implementation, still with reference to FIG. 5, a first electrical connector 15 is disposed on at least one side of the front inserting board 11, and a second electrical connector 16 is disposed on at least one side of the rear inserting board 12. The front inserting board 11 is pluggably connected to the rear inserting board 12 by using the first electrical connector 15 and the second electrical connector 16. In this embodiment of this application, the front inserting board 11 and the rear inserting board 12 implement an electrical signal connection by using an electrical connector, and the electrical connector occupies relatively small space, so that the interconnection space between the front inserting board 11 and the rear inserting board 12 may be relatively small. In specific implementation, the first electrical connector 15 may be disposed on the surface of the front inserting board 11. Alternatively, the first electrical connector 15 may be disposed on a side of the front inserting board 11 facing the rear inserting board 12, and a position of the first electrical connector 15 may be determined based on an actual situation, which is not limited herein. Similarly, the second electrical connector 16 may be disposed on the surface of the rear inserting board 12. Alternatively, the second electrical connector 16 may be disposed on a side of the rear inserting board 12 facing the front inserting board 11, and a position of the second electrical connector 16 may be determined based on an actual situation, which is not limited herein. In specific implementation, each front inserting board 11 and any rear inserting board 12 may implement the electrical signal connection by using one pair, two pairs, or more pairs of electrical connectors. Each pair of electrical connectors includes one first electrical connector 15 and one second electrical connector 16. A quantity of first electrical connectors 15 and a quantity of second electrical connectors 16 may be set based on an actual requirement. This is not limited herein.

For example, the first electrical connector 15 and the second electrical connector 16 may be an elbow male connector and an elbow female connector respectively. Alternatively, the first electrical connector 15 and the second electrical connector 16 may be a spring plate and a contact respectively. Alternatively, the first electrical connector 15 and the second electrical connector 16 may be other structures that can implement the electrical signal connection. This is not limited herein.

In actual application, the first electrical connector 15 may be electrically connected to the front inserting board 11 by crimping, welding, or the like, and the second electrical connector 16 may be electrically connected to the rear inserting board 12 by crimping, welding, or the like. Therefore, usually, the first electrical connector 15 is disposed on the surface of the front inserting board 11, and the second electrical connector 16 is disposed on the surface of the rear inserting board 12.

In a possible implementation, the at least one front inserting board may be pluggably connected to the at least one rear inserting board by using at least two first electrical connectors and at least two second electrical connectors. In other words, the at least one front inserting board and the at least one rear inserting board may implement the electrical signal connection by using at least two pairs of electrical connectors. In specific implementation, the at least two first electrical connectors may be disposed on two sides of the front inserting board, and the at least two second electrical connectors may be disposed on two sides of the rear inserting board. In specific implementation, positions and a quantity of electrical connectors may be determined based on space between the front inserting board and the rear inserting board. This is not limited herein.

Still with reference to FIG. 5, in some embodiments of this application, the optical connector and the electrical connector are required to connect the front inserting board 11 and the rear inserting board 12. Because the electrical connector is usually connected to the front inserting board 11 or the rear inserting board 12 in a form of an electrical signal by crimping, welding, or the like, the electrical connector is usually disposed on the surface of the front inserting board 11 or the rear inserting board 12. Therefore, the first electrical connector 15 needs to be disposed on the surface of the front inserting board 11, and the second electrical connector 16 needs to be disposed on the surface of the rear inserting board 12. To properly use the interconnection space between the front inserting board 11 and the rear inserting board 12, the first optical connector 13 and the first electrical connector 15 may be disposed in a stacked manner. For example, for the front inserting board 11 that is closest to the top in FIG. 5, the first optical connector 13 is disposed above the first electrical connector 15. To implement the optical signal connection between the first optical connector 13 and the front inserting board 11, the first optical component (not shown in the figure) may be further disposed on the surface of the front inserting board 11, and the first optical connector 13 is connected to the surface of the front inserting board 11 by using the first optical component. In this way, optical signal transmission between the first optical connector 13 and the front inserting board 11 may be implemented by using the transfer function of the first optical component. In addition, the interconnection space between the front inserting board 11 and the rear inserting board 12 may be properly used, so that the positions of each optical connector and each electrical connector are relatively compact, and the interconnection space between the front inserting board 11 and the rear inserting board 12 is relatively small.

In addition, in some other embodiments of this application, the second optical connector 14 and the second electrical connector 16 may also be disposed in a stacked manner in a direction perpendicular to the surface of the rear inserting board 12 (that is, a direction shown by an arrow x in the figure). In this way, the second optical component may be disposed on the surface of the rear inserting board 12, so that the second optical connector 14 is connected to the surface of the rear inserting board 12 by using the second optical component.

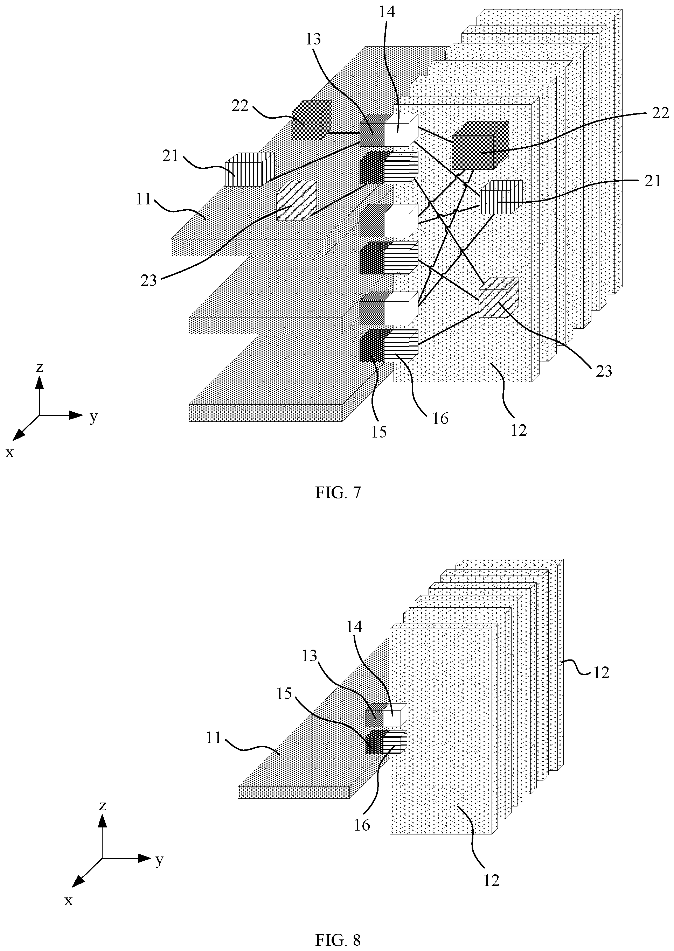

FIG. 7 is another schematic diagram of a three-dimensional structure of an optical cross-connect architecture according to an embodiment of this application. As shown in FIG. 7, a thick solid line in FIG. 7 represents a connection line in the optical signal distribution module or the electrical signal transmission module. A thick solid line connected to the optical connector represents a connection line in the optical signal distribution module, and a thick solid line connected to the electrical connector represents a connection line in the electrical signal transmission module. In specific implementation, devices such as a pluggable optical module 21 and an optical signal processing chip 22 may be disposed on the surface of the front inserting board 11 and/or the rear inserting board 12. The optical signal processing chip 22 may be a service processing chip, a cross processing chip, a wavelength processing chip, or the like. The pluggable optical module 21 and the optical signal processing chip 22 each are connected to the optical connector by using the optical signal distribution module. A medium of the optical signal distribution module may be an optical fiber, a ribbon fiber, or a waveguide medium. In addition, an electrical signal processing chip 23 may be further disposed on the surface of the front inserting board 11 and/or the rear inserting board 12, and the electrical signal processing chip 23 may be an electrical-layer service processing chip, a cross-connect chip, or the like. The electrical signal processing chip 23 may be connected to the electrical connector by using the electrical signal transmission module, and a medium of the electrical signal transmission module may be a copper wire, a cable, or the like.

FIG. 8 is another schematic diagram of a three-dimensional structure of an optical cross-connect architecture according to an embodiment of this application. As shown in FIG. 8, the optical cross-connect architecture may include one front inserting board 11 and a plurality of rear inserting boards 12, and the electrical signal transmission module may be disposed in the front inserting board 11. Each rear inserting board 12 may be respectively connected to each electrical signal output end of the electrical signal transmission module in a form of an electrical signal, and an electrical signal of the front inserting board 11 is transmitted to each rear inserting board 12 by using a transmission function of the electrical signal transmission module. In this way, electrical signal transmission between the front inserting board 11 and the rear inserting board 12 is implemented. Certainly, the electrical signal transmission module may also be disposed in the rear inserting board 12, which is not limited herein.

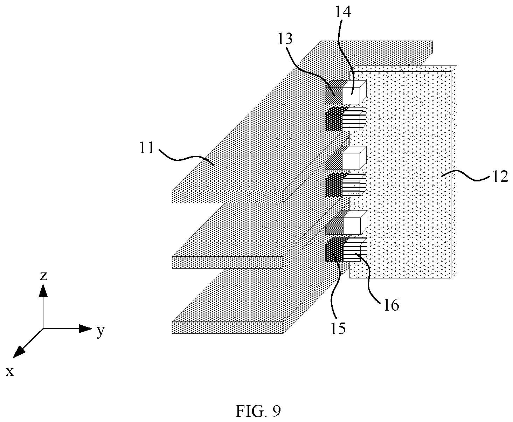

FIG. 9 is another schematic diagram of a three-dimensional structure of an optical cross-connect architecture according to an embodiment of this application. As shown in FIG. 9, the optical cross-connect architecture may include one rear inserting board 12 and a plurality of front inserting boards 11, and the electrical signal transmission module may be disposed in the rear inserting board 12. Each front inserting board 11 may be respectively connected to each electrical signal output end of the electrical signal transmission module in a form of an electrical signal, and the electrical signal of the rear inserting board 12 is transmitted to each front inserting board 11 by using the transmission function of the electrical signal transmission module. In this way, the electrical signal transmission between the front inserting board 11 and the rear inserting board 12 is implemented. Certainly, the electrical signal transmission module may also be disposed in the front inserting board 11, which is not limited herein.

In some embodiments of this application, as shown in FIG. 5, the optical cross-connect architecture may include a plurality of front inserting boards 11 and a plurality of rear inserting boards 12, and the electrical signal transmission module may be disposed in the at least one front inserting board 11. Each rear inserting board 12 may be respectively connected to each electrical signal output end of the electrical signal transmission module in a form of an electrical signal, and the electrical signal of the front inserting board 11 is transmitted to each rear inserting board 12 by using the transmission function of the electrical signal transmission module. In this way, the electrical signal transmission between the front inserting board 11 and the rear inserting board 12 is implemented. Alternatively, the electrical signal transmission module may be disposed in the at least one rear inserting board 12. Each front inserting board 11 may be respectively connected to each electrical signal output end of the electrical signal transmission module in a form of an electrical signal, and the electrical signal of the rear inserting board 12 is transmitted to each front inserting board 11 by using the transmission function of the electrical signal transmission module. In this way, the electrical signal transmission between the front inserting board 11 and the rear inserting board 12 is implemented. Optionally, the electrical signal transmission module may be disposed in each front inserting board 11 and each rear inserting board 12, so that the electrical signal connection between the plurality of front inserting boards 11 and the plurality of rear inserting boards 12 can be implemented.

Based on a same technical concept, an embodiment of this application further provides a communication device. The communication device may include any one of the foregoing optical cross-connect architectures and a housing. The housing covers the optical cross-connect architecture. The communication device may be an optical communication device, a router, a switch, a server, or the like. Because an optical backboard in a conventional technology is omitted in the foregoing optical cross-connect architecture, the interconnection space between the front inserting board and the rear inserting board in the optical cross-connect architecture is relatively small, and available space between the front inserting board and the rear inserting board is relatively large. In this way, the front inserting board and the rear inserting board can integrate more functions, and functions of the communication device including the optical cross-connect architecture are enriched. In addition, a distance between the front inserting board and the rear inserting board is relatively short, and insertion loss of the optical cross-connect architecture is relatively small, so that performance of the communication device including the optical cross-connect architecture is relatively good.

Although preferred embodiments of this application are described, persons skilled in the art can make changes and modifications to these embodiments after they learn of a basic inventive concept. Therefore, the appended claims are intended to be construed as including the preferred embodiments and all changes and modifications that fall within the scope of this application.

Clearly, persons skilled in the art can make various modifications and variations to embodiments of this application without departing from the spirit and scope of embodiments of this application. In this case, this application is intended to cover these modifications and variations of the embodiments of this application provided that they fall within the scope of protection defined by the following claims and their equivalent technologies.

## Claims

1. An optical cross-connect architecture, comprising: at least one front inserting board and at least one rear inserting board, wherein
each front inserting board is orthogonal to any rear inserting board, one side face of each front inserting board is disposed opposite to one side face of any rear inserting board, and each rear inserting board is located on a same side of any front inserting board;
each front inserting board is pluggably connected to any rear inserting board; and
an optical signal distribution module is disposed in the at least one front inserting board; and/or, an optical signal distribution module is disposed in the at least one rear inserting board.

2. The optical cross-connect architecture according to claim 1, wherein the optical signal distribution module comprises: at least one optical signal receiving end, at least one optical signal output end, and an optical signal distribution component, wherein the optical signal distribution component is configured to distribute an optical signal of each optical signal receiving end to each optical signal output end.

3. The optical cross-connect architecture according to claim 1 or 2, wherein a first optical connector is disposed on at least one side of the front inserting board, and a second optical connector is disposed on at least one side of the rear inserting board; and
the front inserting board is pluggably connected to the rear inserting board by using the first optical connector and the second optical connector

4. The optical cross-connect architecture according to claim 3, wherein a first optical component is disposed on a surface of the front inserting board, and the first optical connector is connected to the front inserting board in a form of an optical signal by using the first optical component; and
a second optical component is disposed on a surface of the rear inserting board, and the second optical connector is connected to the rear inserting board in a form of an optical signal by using the second optical component.

5. The optical cross-connect architecture according to claim 3, wherein the at least one front inserting board is pluggably connected to the rear inserting board by using at least two first optical connectors and at least two second optical connectors;
the at least two first optical connectors are disposed on one side of the front inserting board in a stacked manner, and the at least two second optical connectors are disposed on one side of the rear inserting board in a stacked manner; or
the at least two first optical connectors are distributed on two sides of the front inserting board, and the at least two second optical connectors are distributed on two sides of the rear inserting board.

6. The optical cross-connect architecture according to any one of claims 1 to 5, wherein an electrical signal transmission module is disposed in the at least one front inserting board; and/or an electrical signal transmission module is disposed in the at least one rear inserting board.

7. The optical cross-connect architecture according to claim 6, wherein the electrical signal transmission module has at least one electrical signal receiving end and at least one electrical signal output end, and the electrical signal transmission module is configured to transmit an electrical signal of each electrical signal receiving end to each electrical signal output end.

8. The optical cross-connect architecture according to claim 6, wherein a first electrical connector is disposed on at least one side of the front inserting board, and a second electrical connector is disposed on at least one side of the rear inserting board; and
the front inserting board is pluggably connected to the rear inserting board by using the first electrical connector and the second electrical connector.

9. The optical cross-connect architecture according to any one of claims 1 to 8, wherein the optical cross-connect architecture comprises one front inserting board and a plurality of rear inserting boards; or the optical cross-connect architecture comprises one rear inserting board and a plurality of front inserting boards; or the optical cross-connect architecture comprises a plurality of front inserting boards and a plurality of rear inserting boards.

10. A communication device, comprising the optical cross-connect architecture according to any one of claims 1 to 9 and a housing, wherein the housing covers the optical cross-connect architecture.
